# EUROPEAN PATENT SPECIFICATION

(11) **EP 4 311 034 B1**
(45) Date of publication and mention of the grant of the patent: **17.06.2026**
(21) Application number: 22185908.5
(22) Date of filing: 20.07.2022
(51) Int. Cl.: H01R 12/72, H05K 3/30, H01R 12/58

(54) **ELECTRONIC ASSEMBLY**
STIFTAUSRICHTUNGSPLATTE, VERBINDER UND ELEKTRONISCHE ANORDNUNG
PLAQUE D'ALIGNEMENT DE BROCHES, CONNECTEUR ET ENSEMBLE ÉLECTRONIQUE

(43) Date of publication of application: 24.01.2024
(73) Proprietor: Veoneer Sweden Safety Systems AB, 10302 Stockholm (SE)
(72) Inventor: SAVIN, Anatolie, 700051 Iasi (RO); CACU, Adrian, 700051 Iasi (RO)
(74) Representative: Reichert & Lindner Partnerschaft Patentanwälte

(56) References cited:
- DE-A1- 102018 000 940
- US-A1- 2003 166 348

## Description

The invention relates to an electronic assembly, as may for example be used in the automotive sector.

Some connectors used, for example in the automotive sector, have electrically conducting pins to establish an electrical connection between a printed circuit board and a port on the connector, like for instance a socket for a plug. In order to assure correct position of the pins relative to the printed circuit board a pin alignment plate is often employed.

The pin alignment plate, for various constructive reasons and assembly requirements, cannot be sandwiched between the printed circuit board and a housing of the connector without a distance in between, rather there will be a defined distance, or gap, between the printed circuit board and the pin alignment plate. Nonetheless, the pin alignment plate has to be attached firmly to the housing of the connector. One possibility to achieve this is heat staking, which, however, is often not used due to space limitations or for reasons of cost reduction. Therefore, different approaches are often used. One such approach is to attach the pin alignment plate to the housing by means provided at the circumference of the pin alignment plate which engage corresponding means provided on the housing. For example, the pin alignment plate may have holes at opposite ends which slide over pins on the housing. This approach fixes the pin alignment plate to the housing by fixing its ends to the housing. The geometry of the pin alignment plate, which often is long, narrow, and thin, is prone to lead to resonance vibrations, which are a source of noise, produce wear and thus loose particles in the connector. These vibrations can cause the entire pin alignment plate to become loose and move between the connector housing and the printed circuit board. And even if the ends of the pin alignment plate remain secured to the housing, the pin alignment plate may vibrate and hit the printed circuit board repeatedly. Due to the damage and general wear this may cause, such a situation is highly undesirable.

German patent application DE 10 2018 000 940 A1 discloses a connector and an assembly of the connector and a circuit board and a pin alignment plate. The pin alignment plate is in gapless contact with the circuit board.

It is an object of the invention to provide an electronic assembly with a printed circuit board and with a connector having a pin alignment plate, in which electronic assembly such vibration of the pin alignment plate is avoided.

This object is achieved by an electronic assembly according to claim 1.

The pin alignment plate in the electronic assembly according to the invention has means for attaching the pin alignment plate to a housing at a circumference of the pin alignment plate; for example, such means can be provided at opposite ends of the pin alignment plate. The pin alignment plate is intended for aligning electrically conductive pins, and for this purpose the pin alignment plate has holes for inserting such pins. These holes appear as openings in opposite surfaces of the pin alignment plate, in particular as openings in a surface opposite the side of the pin alignment plate from which the pins are to be inserted. According to the invention, on this latter surface an elastic feature shaped like an arch protruding from this surface is provided; the elastic feature is elastically deformable in a direction normal to the surface.

The elastic feature is brought in contact with the printed circuit board of the electronic assembly, without the elastic feature being firmly connected with the printed circuit board. The elastic deformation of the elastic feature normal to the surface reduces or even eliminates vibrations of the pin alignment plate and thus noise and the risk of damage of the printed circuit board, of the pin alignment plate and of the pins inserted therein. In each specific application case of the invention, the elasticity of the elastic feature, i.e., the elastic restoring force arising due to a deformation of the elastic feature, is tailored such that vibrations of the pin alignment plate are efficiently suppressed, without the elastic restoring force impeding assembly, in particular the proper contacting between pins aligned by the pin alignment plate and a printed circuit board shall not be hindered.

In an embodiment, the holes for the pins in the pin alignment plate are arranged in groups, and therefore the openings of the holes on the surface with the elastic feature are arranged in groups. Between such groups there are areas on the surface free of such openings for pins. The elastic feature is located in such an area free of openings for pins. The arrangement of the holes / openings into groups is dictated by a layout of the printed circuit board contacted with the pins aligned by the pin alignment plate.

Using a free area between such groups as location for the elastic feature allows implementing the invention without redesigning the printed circuit board.

In an embodiment, the elastic feature is of the same material as the pin alignment plate, and in particular may be integral with the pin alignment plate. Preferentially, the elastic feature is formed at the same time the pin alignment plate is formed. This implies that manufacture of the pin alignment plate according to the invention is rather simple and does not require extra steps like assembly and mounting of the elastic feature.

In an embodiment, the pin alignment plate comprises more than one elastic feature protruding from the surface of the pin alignment plate. Each such elastic feature is as described above. With more than one elastic feature these features can be distributed on the surface of the pin alignment plate in a way that leads to a particularly efficient suppression of vibrations of the pin alignment plate. Such distributions can for example be determined by experiment and/or simulation. Also, the elastic forces from plural elastic features may add up to a larger resulting force, which is useful in cases where the elastic force from a single elastic feature, due to shape of the feature and/or elastic properties of the material of the elastic feature, is not sufficient for a desired reduction of vibrations of the pin alignment plate.

A connector in the electronic assembly according to the invention has a housing and a plurality of electrically conducting pins, as well as a pin alignment plate as described above. The electrically conducting pins are inserted into the holes of the pin alignment plate. The elastic feature is on a side of the pin alignment plate on which there are the free ends of the electrically conducting pins. The pin alignment plate is attached to the housing of the connector by means at the circumference of the pin alignment plate.

The electronic assembly according to the invention has a printed circuit board and a connector as just described. The electrically conducting pins are in electrical contact with the printed circuit board. There is a gap between the surface of the pin alignment plate and the printed circuit board. The elastic feature is in mechanical contact with the printed circuit board. This mechanical contact reduces or eliminates vibrations of the pin alignment plate.

Below the invention and its advantages are described with reference to the accompanying figures.
- Figure 1: shows a prior art connector.
- Figure 2: shows a detail of Fig. 1.
- Figure 3: shows a detail of Fig. 1 as a section view.
- Figure 4: illustrates a problem with prior art.
- Figure 5: illustrates a problem with prior art.
- Figure 6: shows an embodiment of a connector as used in the invention.
- Figure 7: shows a detail of Fig. 6.
- Figure 8: shows a detail of an electronic assembly in a section view.
- Figure 9: shows a further embodiment of a connector as used in the invention.
- Figure 10: shows a further embodiment of a connector as used in the invention.
- Figure 11: shows an example of a connector not part of the invention.

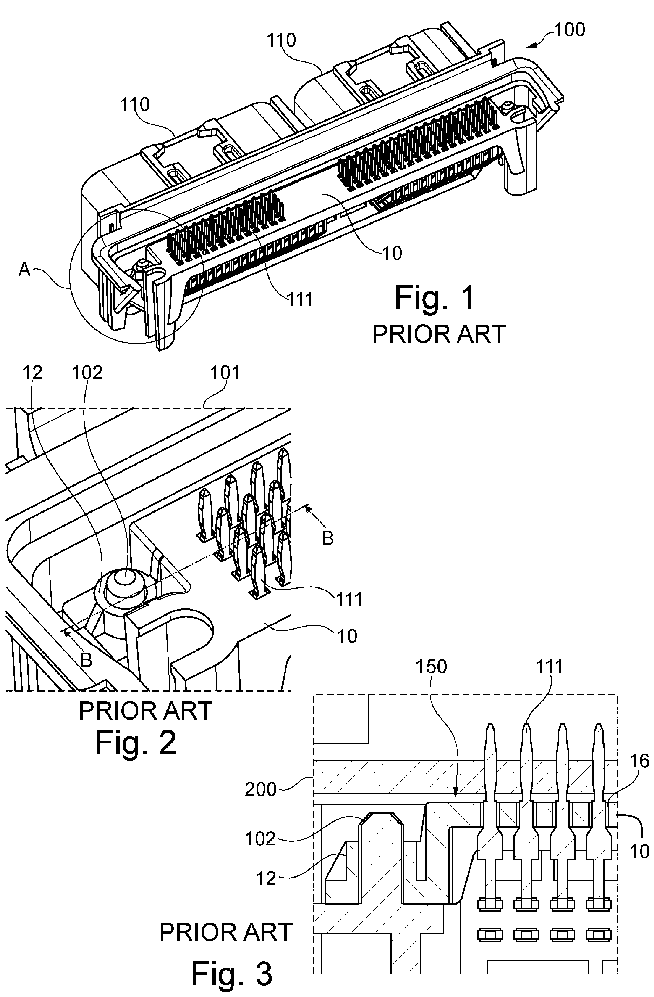

The figures 1 - 10 are only examples of how the invention can be implemented and are therefore not intended as a limitation of the invention to the specific examples shown in the figures.

**Fig. 1** shows a prior art connector 100 with two sockets 110 for receiving plugs and a plurality of pins 111. The pins 111 are aligned by a pin alignment plate 10.

**Fig. 2** shows a detail from within the area marked with circle A in Fig. 1. Shown are part of the pin alignment plate 10 and of connector housing 101, as well as some pins 111. A fixing hole 12 is formed at the circumference of the pin alignment plate 10, into which is inserted a fixing pin 102 on the housing 101. The fixing hole 12 is a means for attaching the pin alignment plate 10 to the housing 101, by cooperation with the fixing pin 102.

**Fig. 3** is a section along the line BB shown in Fig. 2, in the case where in addition to the situation shown in Fig. 2 also a printed circuit board 200 is attached to the connector 100. Shown in section view are the fixing pin 102, the pin alignment plate 10 with fixing hole 12 and pins 111; the pins 111 are inserted through holes 16 in the pin alignment plate 10. As can be seen, there is a narrow gap 150 between the pin alignment plate 10 and the printed circuit board 200.

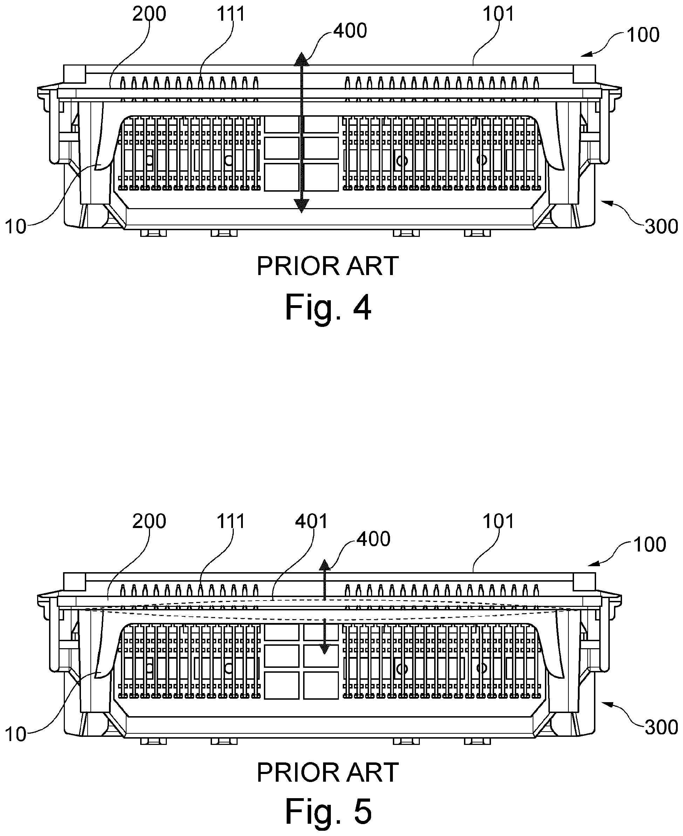

**Fig. 4** shows a prior art electronic assembly 300 comprising a connector 100 with housing 101 and pins 111, a pin alignment plate 10 and a printed circuit board 200. While fixing hole 12 and fixing pin 102 discussed in the context of Figs. 2 and 3 are intended to fix pin alignment plate 10 to housing 101, this fixing may fail if the electronic assembly 300 is exposed to vibrations, for example due to the motion of a vehicle including the electronic assembly 300. If this fixing fails completely, the pin alignment plate 10 becomes free to move in a direction indicated by double arrow 400, in particular, the pin alignment plate 10 can bump against the printed circuit board 200, which is highly undesirable.

**Fig. 5** shows the same prior art electronic assembly 300 as Fig. 4, where most elements have already been discussed. Fig. 5 illustrates the case that the fixing of the pin alignment plate 10 to the housing 101 does not fail. However, as the pin alignment plate 10 is thin, narrow, and long, vibrations of the pin alignment plate 10 can easily be stimulated, e.g., in a resonant fashion, for example due to the motion of a vehicle including the electronic assembly 300. This leads to an oscillatory deformation of the pin alignment plate 10 in the direction indicated by double arrow 400, and as also shown by lines 401, which represent deformations of the pin alignment plate 10. These oscillatory deformations cause the pin alignment plate 10 to bump against the printed circuit board 200, so this highly undesirable effect may occur even if the ends of the pin alignment plate 10 remain properly fixed to the housing 101.

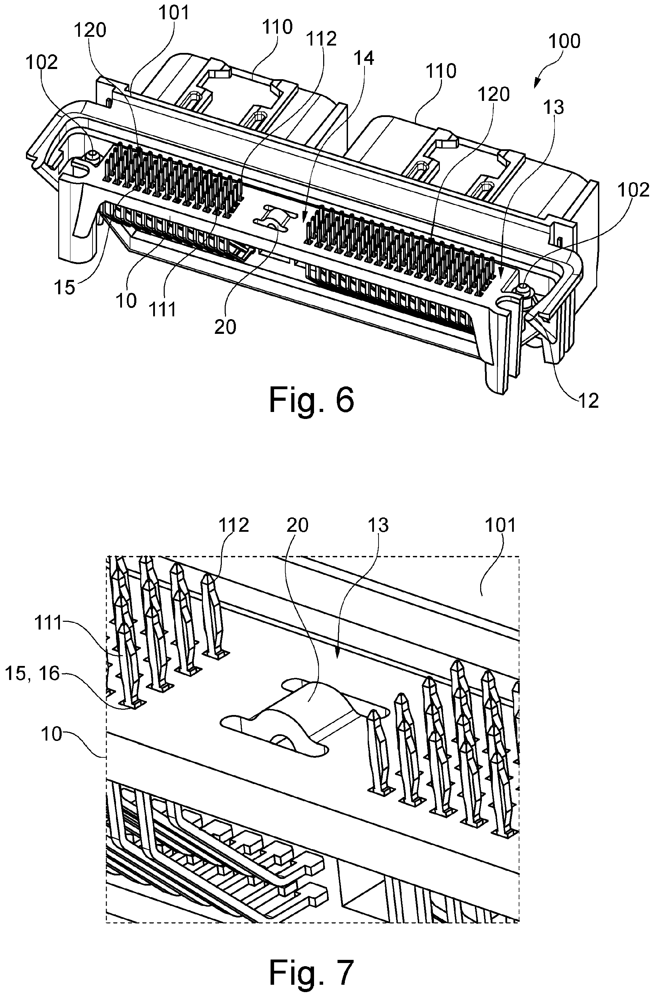

**Fig. 6** shows a connector 100 as used in the invention with pin alignment plate 10, pins 111, housing 101 and sockets 110 for plugs. The pin alignment plate 10 is secured to the housing 101 at opposite ends by fixing pins 102 on the housing 101 and fixing holes 12 on the pin alignment plate 10, in the same way as discussed for the prior art in Figs. 1 to 3. According to the invention, an elastic feature 20 is provided on the pin alignment plate 10. The elastic feature 20 is protruding from a surface 13 of the pin alignment plate 10 which is on the same side of the pin alignment plate 10 as the free ends 112 of the pins 111. This surface 13 is also the surface with openings 15 of the holes for the pins 111 on the side of the pin alignment plate 10 opposite the side from which the pins 111 are inserted through the pin alignment plate 10.

In the embodiment shown, the pins 111, and correspondingly the openings 15, are divided into two groups 120, each group 120 pertaining to one of the sockets 110.

Between the two groups 120 there is an area 14 on the surface 13 of the pin alignment plate 10 which is free of openings 15 for pins 111. The elastic feature 20 is located in this area 14.

**Fig. 7** is a detail of the connector 100 shown in Fig. 6. Shown are parts of the housing 101 and of the pin alignment plate 10. The pins 111 are passed through holes 16 in the pin alignment plate 10, which holes 16 appear as openings 15 on surface 13. The elastic feature 20 protruding from surface 13 is shaped like an arch. The surface 13 and the elastic feature 20 are on that side of the pin alignment plate 10 on which there are the free ends 112 of the pins 111.

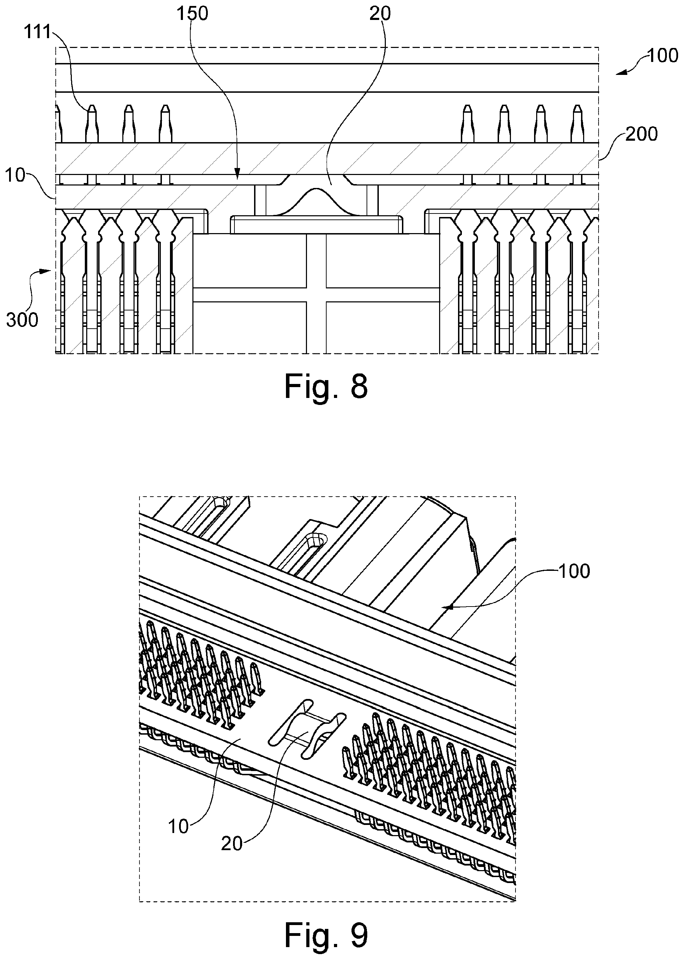

**Fig. 8** is a section of an electronic assembly 300 according to the invention, having the connector 100 of Fig. 6 and a printed circuit board 200. Shown are also pin alignment plate 10 with elastic feature 20 and pins 111 in electrical contact with the printed circuit board 200. There is a gap 150 between the printed circuit board 200 and the pin alignment plate 10. The elastic feature 20 is in mechanical contact with the printed circuit board 200 and thus bridges the gap 150. This contact reduces potential vibrations of the pin alignment plate 10.

**Fig. 9** shows a connector 100 with an alternative embodiment of the pin alignment plate 10 as used in the invention. Here the elastic feature 20 is also shaped like an arch, but its orientation is rotated by 90 degrees relative to the embodiment of Fig. 6.

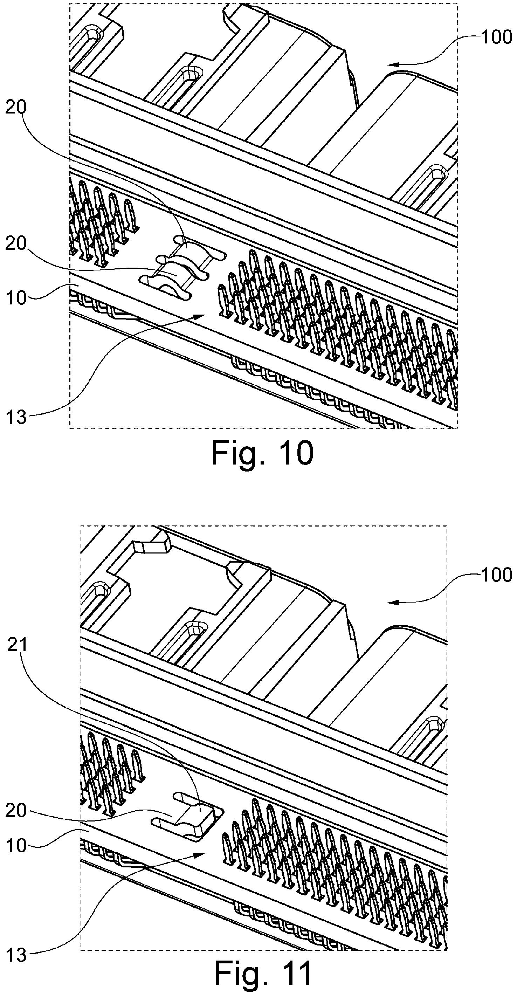

**Fig. 10** shows a connector 100 with an alternative embodiment of the pin alignment plate 10 as used in the invention. Here two elastic features 20 protrude from surface 13 of the pin alignment plate 10. Both elastic features 20 are shaped like an arch.

**Fig. 11** shows a connector 100 with an example of the pin alignment plate 10 not part of the invention. Here the elastic feature 20 is a cantilever, the free end 21 of which protrudes from the surface 13.

### List of Reference Signs

- 10: pin alignment plate
- 12: fixing hole
- 13: surface
- 14: area (of surface)
- 15: opening
- 16: hole
- 20: elastic feature
- 21: free end (of elastic feature)
- 100: connector
- 101: housing
- 102: fixing pin
- 110: socket
- 111: pin
- 112: free end (of pin)
- 120: group (of openings)
- 150: gap
- 200: printed circuit board
- 300: electronic assembly
- 400: double arrow
- 401: line

## Claims

1. Electronic assembly (300) with a printed circuit board (200) and a connector (100),
the connector (100) including
a housing (101),
a plurality of electrically conducting pins (111), and
a pin alignment plate (10) attached to the housing (101) of the connector (100) by means (12) at the circumference of the pin alignment plate (10);
the pin alignment plate (10) having
a surface (13) with openings (15) of holes (16) in the pin alignment plate (10), wherein the electrically conducting pins (111) are inserted into the holes (16) of the pin alignment plate (10) from a side of the pin alignment plate (10) opposite the surface (13), and
an elastic feature (20) protruding from the surface (13), the elastic feature (20) elastically deformable in a direction normal to the surface (13), the elastic feature (20) on a side of the pin alignment plate (10) on which there are the free ends (112) of the electrically conducting pins (111);
wherein the electrically conducting pins (111) are in electrical contact with the printed circuit board (200);
wherein there is a gap (150) between the surface (13) of the pin alignment plate (10) and the printed circuit board (200); and
wherein the elastic feature (20) is in mechanical contact with the printed circuit board (200);
**characterized in that**
the elastic feature (20) is shaped like an arch protruding from the surface (13) of the pin alignment plate (10).

2. Electronic assembly (300) according to claim 1, wherein the openings (15) on the surface (13) of the pin alignment plate (10) are arranged into groups (120) with an area (14) of the surface (13) between the groups (120) free of openings (15) for the pins (111), and wherein the elastic feature (20) is located in the area (14) free of openings (15) for the pins (111).

3. Electronic assembly (300) according to one of the claims 1 or 2, wherein the elastic feature (20) is of the same material as the pin alignment plate (10).

4. Electronic assembly (300) according to one of the claims 1 to 3, wherein the pin alignment plate (10) comprises more than one elastic feature (20) protruding from the surface (13) of the pin alignment plate (10) and elastically deformable in a direction normal to the surface (13) of the pin alignment plate (10).

## Patentansprüche

1. Elektronische Baugruppe (300) mit einer Leiterplatte (200) und einem Verbinder (100),
der Verbinder (100) umfassend
ein Gehäuse (101),
eine Vielzahl von elektrisch leitenden Stiften (111) und
eine Stiftausrichtungsplatte (10), die am Gehäuse (101) des Verbinders mittels Mitteln (12) am Umfang der Stiftausrichtungsplatte (10) (100) befestigt ist;
die Stiftausrichtungsplatte (10) aufweisend
eine Oberfläche (13) mit Öffnungen (15) von Löchern (16) in der Stiftausrichtungsplatte (10), wobei die elektrisch leitenden Stifte (111) von einer der Oberfläche (13) gegenüberliegenden Seite der Stiftausrichtungsplatte (10) in die Löcher (16) der Stiftausrichtungsplatte (10) eingeführt werden, und
ein elastisches Element (20), das aus der Oberfläche (13) herausragt, wobei das elastische Element (20) in einer Richtung senkrecht zur Oberfläche (13) elastisch verformbar ist, wobei sich das elastische Element (20) auf einer Seite der Stiftausrichtungsplatte (10) befindet, auf der sich die freien Enden (112) der elektrisch leitenden Stifte (111) befinden;
wobei die elektrisch leitenden Stifte (111) in elektrischem Kontakt mit der Leiterplatte (200) stehen;
wobei zwischen der Oberfläche (13) der Stiftausrichtungsplatte (10) und der Leiterplatte (200) ein Spalt (150) vorhanden ist; und
wobei das elastische Element (20) in mechanischem Kontakt mit der Leiterplatte (200) steht;
**dadurch gekennzeichnet, dass**
das elastische Element (20) wie ein Bogen geformt ist, der aus der Oberfläche (13) der Stiftausrichtungsplatte (10) herausragt.

2. Elektronische Baugruppe (300) nach Anspruch 1, wobei die Öffnungen (15) auf der Oberfläche (13) der Stiftausrichtungsplatte (10) in Gruppen (120) angeordnet sind, wobei ein Bereich (14) der Oberfläche (13) zwischen den Gruppen (120) frei von Öffnungen (15) für die Stifte (111) ist, und wobei sich das elastische Element (20) in dem Bereich (14) befindet, der frei von Öffnungen (15) für die Stifte (111) ist.

3. Elektronische Baugruppe (300) nach einem der Ansprüche 1 oder 2, wobei das elastische Element (20) aus dem gleichen Material wie die Stiftausrichtungsplatte (10) besteht.

4. Elektronische Baugruppe (300) nach einem der Ansprüche 1 bis 3, wobei die Stiftausrichtungsplatte (10) mehr als ein elastisches Element (20) umfasst, das aus der Oberfläche (13) der Stiftausrichtungsplatte (10) herausragt und in einer Richtung senkrecht zur Oberfläche (13) der Stiftausrichtungsplatte (10) elastisch verformbar ist.

## Revendications

1. Ensemble électronique (300) comprenant une carte de circuit imprimé (200) et un connecteur (100),
le connecteur (100) comprenant
un boîtier (101),
une pluralité de broches électriquement conductrices (111), et
une plaque d'alignement des broches (10) fixée au boîtier (101) du connecteur (100) au moyen de moyens (12) situés à la circonférence de la plaque d'alignement des broches (10) ;
la plaque d'alignement des broches (10) présentant
une surface (13) comportant des ouvertures (15) formant des trous (16) dans la plaque d'alignement des broches (10), dans laquelle les broches électriquement conductrices (111) sont insérées dans les trous (16) de la plaque d'alignement des broches (10) depuis un côté de la plaque d'alignement des broches (10) opposé à la surface (13), et
un élément élastique (20) faisant saillie de la surface (13), l'élément élastique (20) étant déformable élastiquement dans une direction normale à la surface (13), l'élément élastique (20) se trouvant sur un côté de la plaque d'alignement des broches (10) sur lequel se trouvent les extrémités libres (112) des broches électriquement conductrices (111) ;
dans lequel les broches électriquement conductrices (111) sont en contact électrique avec la carte de circuit imprimé (200) ;
dans lequel il existe un espace (150) entre la surface (13) de la plaque d'alignement de broches (10) et la carte de circuit imprimé (200) ; et
dans lequel l'élément élastique (20) est en contact mécanique avec la carte de circuit imprimé (200) ;
**caractérisé en ce que**
l'élément élastique (20) a la forme d'un arc faisant saillie de la surface (13) de la plaque d'alignement des broches (10).

2. Ensemble électronique (300) selon la revendication 1, dans lequel les ouvertures (15) sur la surface (13) de la plaque d'alignement des broches (10) sont disposées en groupes (120), une zone (14) de la surface (13) entre les groupes (120) étant dépourvue d'ouvertures (15) pour les broches (111), et dans lequel l'élément élastique (20) est situé dans la zone (14) dépourvue d'ouvertures (15) pour les broches (111).

3. Ensemble électronique (300) selon l'une des revendications 1 ou 2, dans lequel l'élément élastique (20) est constitué du même matériau que la plaque d'alignement des broches (10).

4. Ensemble électronique (300) selon l'une des revendications 1 à 3, dans lequel la plaque d'alignement des broches (10) comprend plus d'un élément élastique (20) faisant saillie de la surface (13) de la plaque d'alignement des broches (10) et déformable élastiquement dans une direction normale à la surface (13) de la plaque d'alignement des broches (10).
